# EUROPEAN PATENT SPECIFICATION

(11) **EP 2 961 611 B1**
(45) Date of publication and mention of the grant of the patent: **01.05.2019**
(21) Application number: 13876732.2
(22) Date of filing: 29.07.2013
(51) Int. Cl.: B41J 2/16, B41J 2/14, B41J 2/045

(54) **TRANSFER MOLDED FLUID FLOW STRUCTURE**
TRANSFERGEFORMTE FLÜSSIGKEITSSTRÖMUNGSSTRUKTUR
STRUCTURE D'ÉCOULEMENT DE FLUIDE MOULÉE PAR TRANSFERT

(30) Priority: 28.02.2013 WO PCT/US2013/028207; 28.02.2013 WO PCT/US2013/028216; 20.03.2013 WO PCT/US2013/033046; 26.03.2013 WO PCT/US2013/033865; 27.06.2013 WO PCT/US2013/048214
(43) Date of publication of application: 06.01.2016
(73) Proprietor: Hewlett-Packard Development Company, L.P., Houston, Texas 77070 (US)
(72) Inventor: CHEN, Chien-Hua, Corvallis, Oregon 97330 (US); CUMBIE, Michael W., Corvallis, Oregon 97330 (US)
(74) Representative: Burger, Markus
(86) International application number: PCT/US2013/052505
(87) International publication number: WO 2014/133577

(56) References cited:
- EP-A2- 1 027 991
- DE-A1-102011 078 906
- JP-A- S61 125 852
- JP-A- 2010 050 452
- US-A- 4 873 622
- US-A- 4 881 318
- US-A1- 2008 061 393
- US-A1- 2009 086 449
- US-A1- 2011 037 808
- US-A1- 2011 037 808
- US-A1- 2011 080 450
- US-A1- 2011 298 868
- US-A1- 2012 000 595
- US-A1- 2013 027 466
- US-B1- 6 250 738
- US-B2- 7 490 924

## Description

### BACKGROUND

A printhead die in an inkjet pen or print bar includes a plurality of fluid ejection elements on a surface of a silicon substrate. Fluid flows to the ejection elements through a fluid delivery slot formed in the substrate between opposing substrate surfaces. While fluid delivery slots adequately deliver fluid to fluid ejection elements, there are some disadvantages with such slots. From a cost perspective, for example, fluid delivery slots occupy valuable silicon real estate and add significant slot processing cost. In addition, lower printhead die cost is achieved in part through shrinking the die, which in turn results in a tightening of the slot pitch and/or slot width in the silicon substrate. However, shrinking the die and the slot pitch increases the inkjet pen costs associated with integrating the small die into the pen during assembly. From a structural perspective, removing material from the substrate to form an ink delivery slot weakens the printhead die. Thus, when a single printhead die has multiple slots (e.g., to provide different colors in a multicolor printhead die, or to improve print quality and speed in a single color printhead die), the printhead die becomes increasingly fragile with the addition of each slot.

US 2011/0037808 A1 discloses a metalized printhead substrate overmolded with plastic. In one embodiment, a printhead die comprises ink delivery pathways fluidically connected to a fluid channel obtained in an overmolded polymer material. An electrically insulating support containing a passageway in fluidic connection with the passageway obtained in the overmolded polymer material is also used.

US 2009/0086449 A1 discloses a method for manufacturing an optical device. In one embodiment, photoresists are placed over optical function regions before a mold is placed over the photoresist. After that, resin is introduced into the mold.

### BRIEF DESCRIPTION OF THE DRAWINGS

The present embodiments will now be described, by way of example, with reference to the accompanying drawings, in which:
FIG. 1 is an elevation section view illustrating one example of a molded fluid flow structure implemented as a printhead structure;
FIG. 2 is a block diagram illustrating an example system implementing a molded fluid flow structure such as the printhead structure of FIG. 1;
FIG. 3 is a block diagram illustrating an inkjet printer implementing one example of a fluid flow structure in a substrate wide print bar;
FIGs. 4-6 illustrate an inkjet print bar implementing one example of a molded fluid flow structure as a printhead structure suitable for use in printer;
FIGs. 7a-e illustrate an example transfer molding process for making a molded printhead fluid flow structure having a transfer molded fluid channel;
FIG. 8 illustrates is a flow diagram of an example transfer molding process corresponding with FIGs. 7a-e;
FIGs. 9-15 illustrate various examples of differently shaped, transfer molded fluid channels that can be formed into a molded body through a transfer mold process.

Throughout the drawings, identical reference numbers designate similar, but not necessarily identical, elements.

### DETAILED DESCRIPTION

### Overview

Reducing the cost of conventional inkjet printhead dies has been achieved in the past through shrinking the die size and reducing wafer costs. The die size depends significantly on the pitch of fluid delivery slots that deliver ink from a reservoir on one side of the die to fluid ejection elements on another side of the die. Therefore, prior methods used to shrink the die size have mostly involved reducing the slot pitch and size through a silicon slotting process that can include, for example, laser machining, anisotropic wet etching, dry etching, combinations thereof, and so on. Unfortunately, the silicon slotting process itself adds considerable cost to the printhead die. In addition, successful reductions in slot pitch are increasingly met with diminishing returns, as the costs associated with integrating the shrinking die (resulting from the tighter slot pitch) with an inkjet pen have become excessive.

A transfer molded fluid flow structure enables the use of smaller printhead dies and a simplified method of forming fluid delivery channels to deliver ink from a reservoir on one side of a printhead die to fluid ejection elements on another side of the die. The fluid flow structure includes one or more printhead dies transfer molded into a monolithic body of plastic, epoxy mold compound, or other moldable material. For example, a print bar implementing the fluid flow structure includes multiple printhead dies transfer molded into an elongated, singular molded body. The molding enables the use of smaller dies by offloading the fluid delivery channels (i.e., the ink delivery slots) from the die to the molded body of the structure. Thus, the molded body effectively grows the size of each die which improves opportunities for making external fluid connections and for attaching the dies to other structures.

The fluid flow structure includes molded fluid delivery channels formed in the structure at the back of each die using a transfer molding process at the wafer or panel level. The transfer mold process provides an overall cost reduction when forming the fluid delivery channels/slots compared to traditional silicon slotting processes. In addition, the transfer mold process enables added flexibility in the molded slot shape, its length, and its side-wall profile, through changes in the topography or design of the mold chase top.

The described fluid flow structure is not limited to print bars or other types of printhead structures for inkjet printing, but may be implemented in other devices and for other fluid flow applications. Thus, in one example, the new structure includes a micro device embedded in a molding having a channel or other path for fluid to flow directly into or onto the device. The micro device can be, for example, an electronic device, a mechanical device, or a microelectromechanical system (MEMS) device. The fluid flow, for example, could be a cooling fluid flow into or onto the micro device, or a fluid flow into a printhead die or other fluid dispensing micro device. These and other examples shown in the figures and described below illustrate but do not limit the invention, which is defined in the Claims following this Description.

As used in this document, a "micro device" means a device having one or more exterior dimensions less than or equal to 30mm; "thin" means a thickness less than or equal to 650µm; a "sliver" means a thin micro device having a ratio of length to width (L/W) of at least three; a "printhead structure" and a "printhead die" mean that part of an inkjet printer or other inkjet type dispenser that dispenses fluid from one or more openings. A printhead structure includes one or more printhead dies. "Printhead structure" and "printhead die" are not limited to printing with ink and other printing fluids but also include inkjet type dispensing of other fluids for uses other than or in addition to printing.

### Illustrative Embodiments

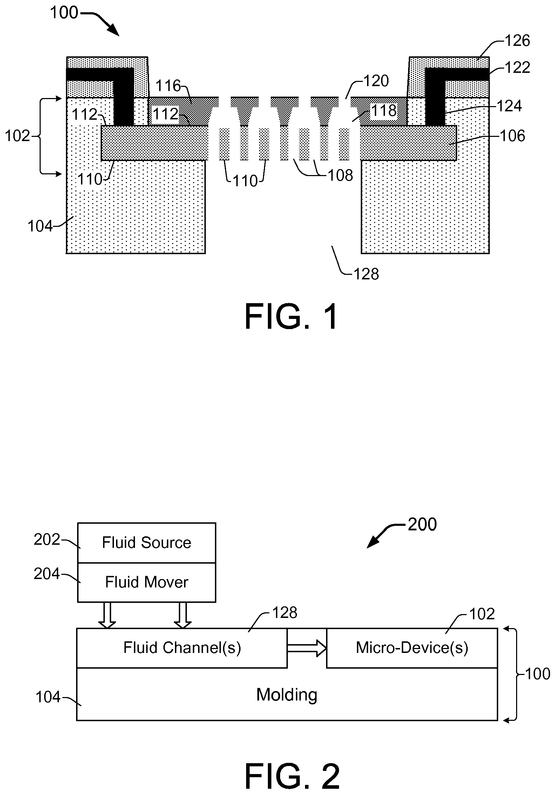

FIG. 1 is an elevation section view illustrating one example of a transfer molded fluid flow structure 100 implemented as a printhead structure 100 that is suitable for use in a print bar of an inkjet printer. The printhead structure 100 includes a micro device 102 molded into a monolithic body 104 of plastic or other moldable material. A molded body 104 may also be referred to herein as a molding 104. In general, a micro device 102 could be, for example, an electronic device, a mechanical device, or a microelectromechanical system (MEMS) device. In the present printhead structure 100 of FIG. 1, micro device 102 is implemented as a printhead die 102. Printhead die 102 includes a silicon die substrate 106 comprising a thin silicon sliver on the order of 100 microns in thickness. The silicon substrate 106 includes fluid feed holes 108 dry etched or otherwise formed therein to enable fluid flow through the substrate 106 from a first exterior surface 110 to a second exterior surface 112.

Formed on the second exterior surface 112 of substrate 106 are one or more layers 116 that define a fluidic architecture that facilitates the ejection of fluid drops from the printhead structure 100. The fluidic architecture defined by layers 116 generally includes ejection chambers 118 having corresponding orifices 120, a manifold (not shown), and other fluidic channels and structures. The layer(s) 116 can include, for example, a chamber layer formed on the substrate 106 with a separately formed orifice layer over the chamber layer, or they can include a monolithic layer that combines the chamber and orifice layers. Layer(s) 116 are typically formed of an SU8 epoxy or some other polyimide material.

In addition to the fluidic architecture defined by layer(s) 116 on silicon substrate 106, the printhead die 102 includes integrated circuitry formed on the substrate 106. Integrated circuitry is formed using thin film layers and other elements not specifically shown in FIG. 1. For example, corresponding with each ejection chamber 118 is a thermal ejector element or a piezoelectric ejector element formed on the second exterior surface 112 of substrate 106. The ejection elements are actuated to eject drops or streams of ink or other printing fluid from chambers 118 through orifices 120.

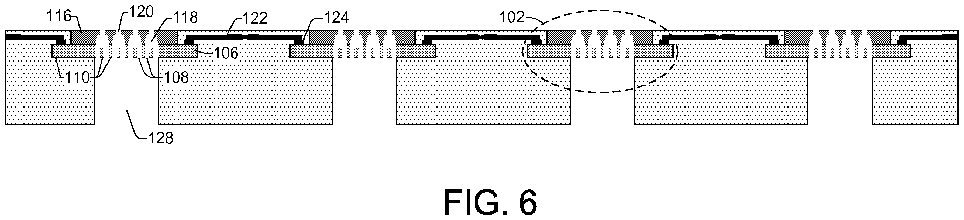

The printhead structure 100 also includes signal traces or other conductors 122 connected to printhead die 102 through electrical terminals 124 formed on substrate 106. Conductors 122 can be formed on structure 100 in various ways. For example, conductors 122 can be formed in an insulating layer 126 as shown in FIG. 1, using a lamination or deposition process. Insulating layer 126 is typically a polymer material that provides physical support and insulation for conductors 122. In other examples, conductors 122 can be molded into the molded body 104 as shown below with regard to FIGs. 6-7 and 9-15.

A transfer molded fluid channel 128 is formed into the molded body 104, and connects with the printhead die substrate 106 at the exterior surface 110. The transfer molded fluid channel 128 provides a pathway through the molded body that enables fluid to flow directly onto the silicon substrate 106 at exterior surface 110, and into the silicon substrate 106 through the fluid feed holes 108, and then into chambers 118. As discussed in further detail below, the fluid channel 128 is formed into the molded body 104 using a transfer molding process that enables the formation of a variety of different channel shapes whose profiles each reflect the inverse shape of whatever mold chase topography is used during the molding process.

FIG. 2 is a block diagram illustrating a system 200 implementing a transfer molded fluid flow structure 100 such as the printhead structure 100 shown in FIG. 1. System 200 includes a fluid source 202 operatively connected to a fluid mover 204 configured to move fluid to a transfer molded channel 128 formed in the fluid flow structure 100. A fluid source 202 might include, for example, the atmosphere as a source of air to cool an electronic micro device 102, or a printing fluid supply for a printhead die 102. Fluid mover 204 represents a pump, a fan, gravity or any other suitable mechanism for moving fluid from source 202 to flow structure 100.

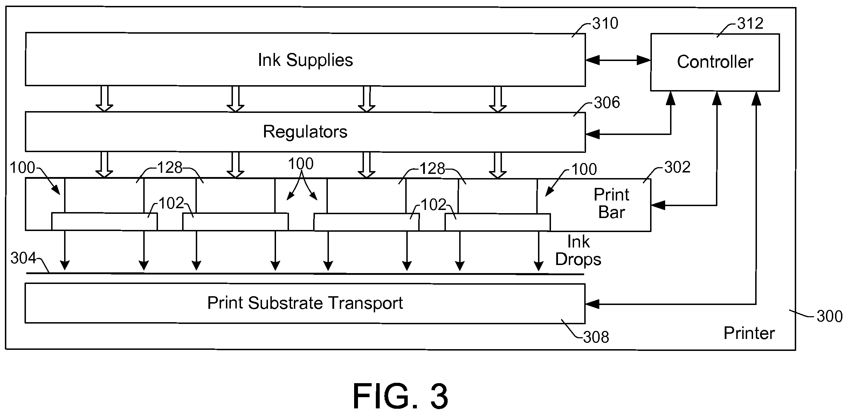

FIG. 3 is a block diagram illustrating an inkjet printer 300 implementing one example of a fluid flow structure 100 in a substrate wide print bar 302. Printer 300 includes print bar 302 spanning the width of a print substrate 304, flow regulators 306 associated with print bar 302, a substrate transport mechanism 308, ink or other printing fluid supplies 310, and a printer controller 312. Controller 312 represents the programming, processor(s) and associated memories, along with other electronic circuitry and components needed to control the operative elements of a printer 300. Print bar 302 includes an arrangement of printhead dies 102 for dispensing printing fluid on to a sheet or continuous web of paper or other print substrate 304. Each printhead die 102 receives printing fluid through a flow path that extends from supplies 310 into and through flow regulators 306, and then through transfer molded fluid channels 128 in print bar 302.

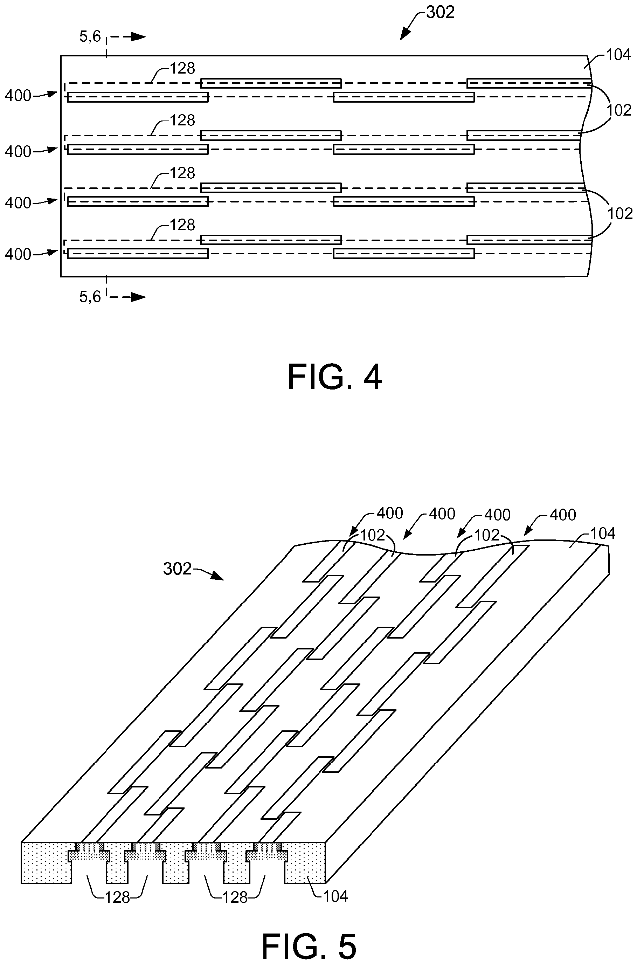

FIGs. 4-6 illustrate an inkjet print bar 302 implementing one example of a transfer molded fluid flow structure 100 as a printhead structure 100 suitable for use in printer 300 of FIG. 3. Referring to the plan view of FIG. 4, printhead dies 102 are embedded in an elongated, monolithic molding 104 and arranged generally end to end in rows 400. The printhead dies 102 are arranged in a staggered configuration in which the dies in each row overlap another printhead die in that same row. In this configuration, each row 400 of printhead dies 102 receives printing fluid from a different transfer molded fluid channel 128 (illustrated with dashed lines in FIG. 4). Although four fluid channels 128 feeding four rows 400 of staggered printhead dies 102 is shown (e.g., for printing four different colors), other suitable configurations are possible. FIG. 5 illustrates a perspective section view of the inkjet print bar 302 taken along line 5-5 in FIG. 4, and FIG. 6 illustrates a section view of the inkjet print bar 302 taken along line 5-5 in FIG. 4. The section view of FIG. 6 shows various details of a printhead structure 100 as discussed above with respect to FIG. 1.

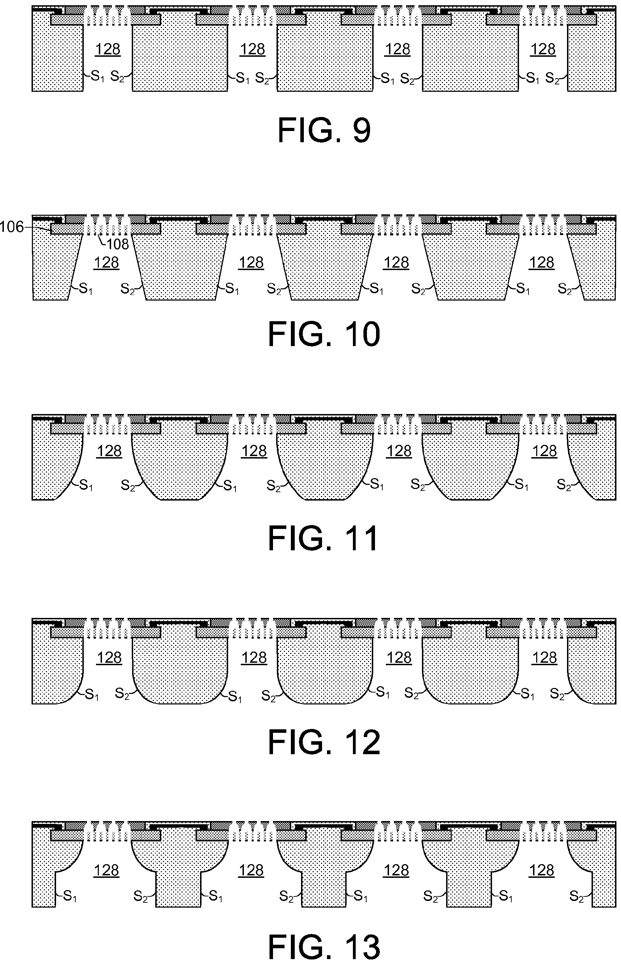

While a particular shape or configuration of a transfer molded fluid channel 128 has been generally illustrated and discussed with reference to FIGs. 1-6, a variety of differently shaped fluid channels 128 can be formed using a transfer mold process. As discussed below, FIGs. 9-15 illustrate examples of differently shaped, transfer molded fluid channels 128 that can be readily formed into a molded body 104 of a fluid flow structure 100 using mold chase tops that have varying topographical designs.

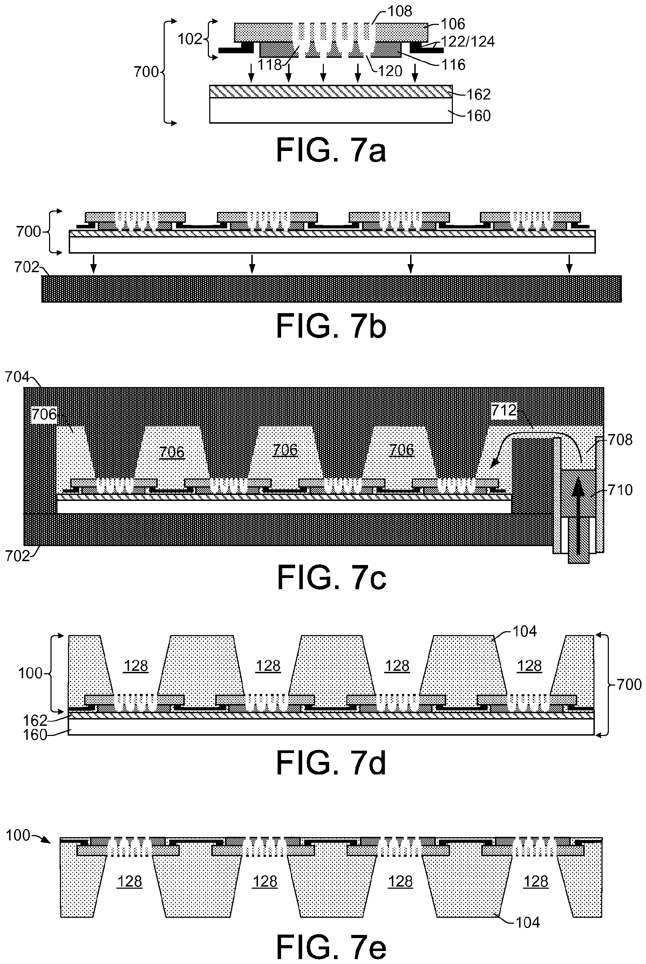

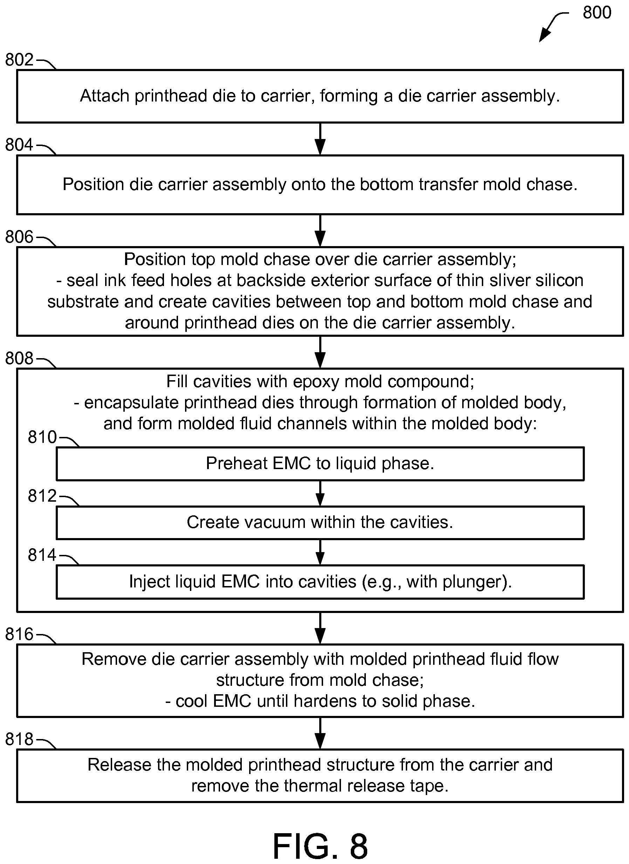

Referring now to FIGs. 7a-e, an example transfer molding process for making a molded printhead fluid flow structure 100 having a transfer molded fluid channel 128 is illustrated. FIG. 8 is a corresponding flow diagram 800 of the process illustrated in FIGs. 7a-e. As shown in FIG. 7a, a printhead die 102 is attached to a carrier 160 using a thermal release tape 162 (step 802 in FIG. 8), forming a die carrier assembly 700. The printhead die 102 is placed with the orifice (120) side down onto the carrier 160, as indicated by the direction arrows. The printhead die 102 is in a pre-processed state such that it already includes layer(s) 116 defining fluidic architectures (e.g., ejection chambers 118, orifices 120), and electrical conductors and terminals 122/124, and ejection elements (not shown) formed on sliver substrate 106. Fluid feed holes 108 have also already been dry etched or otherwise formed in the thin sliver substrate 106.

In a next step, FIG. 7b shows a die carrier assembly 700 similar to the one prepared as shown in FIG. 7a, except that four printhead dies 102 have been attached to the carrier 160. As shown in FIG. 7b, once the dies are attached to the carrier 160, the die carrier assembly 700 is positioned onto the bottom transfer mold chase 702 (step 804 in FIG. 8). As shown in FIG. 7c, after the die carrier assembly 700 is positioned onto the bottom transfer mold chase 702, the top of the transfer mold chase 704 is brought down into position over the die carrier assembly 700 (step 806 in FIG. 8). While the top mold chase 704 can have varying topographies to form differently shaped transfer molded fluid channels 128 into the body 104 of a fluid flow structure 100 (e.g., see FIGs. 9-15), in any case, the topography of the top mold chase 704 is designed such that when positioned over and brought down on the die carrier assembly 700, the mold chase seals the ink feed holes 108 at the backside exterior surface 110 of the thin sliver silicon substrate 106. Positioning the top mold chase 704 over the die carrier assembly 700 seals the ink feed holes 108 and creates cavities 706 between the top and bottom mold chase and around the printhead dies 102 on the die carrier assembly 700. An optional release film can be vacuum held down and conformed to the transfer mold chase to prevent contamination to the transfer mold chase 704 and to minimize the Epoxy mold flash during the transfer mold process.

Referring still to FIG. 7c, in a next step, the cavities 706 are filled with an epoxy molding compound 708 (EMC) or other suitable moldable material (step 808 in FIG. 8). Filling the cavities 706 with EMC forms the molded body 104 that encapsulates the printhead dies 102, and also forms the molded fluid channels 128 within the molded body 104. Typically, filling cavities 706 with EMC involves preheating the EMC until it reaches a melting temperature and becomes a liquid (step 810 in FIG. 8). A vacuum may be created within the cavities 706, and the liquid EMC is then injected using a plunger 710, for example, through runners 712 (i.e., channels) of the mold chase until it reaches and fills the cavities 706 (steps 812 and 814 in FIG. 8). The seals over the ink feed holes 108 created by the top mold chase 704 prevent the EMC from entering the ink feed holes as the cavities are being filled.

After the EMC cools and hardens to a solid, the die carrier assembly 700, which now includes the attached molded printhead fluid flow structure 100, can be removed from the mold chase, as shown in FIG. 7d (step 816 in FIG. 8). FIG. 7d shows the molded printhead fluid flow structure 100 attached to the carrier 160 by the thermal release tape 162. The molded printhead structure 100 is then released from the carrier 160 and the thermal release tape 162 is removed, as shown in FIG. 7e (step 818 in FIG. 8). Thus, in this implementation the molded printhead structure 100 is formed in a transfer mold process. The position of the molded printhead structure 100 in FIG. 7e has been inverted to be consistent with the views of the molded printhead fluid flow structures 100 shown in FIGs. 6 and 9-15.

As mentioned above, the use of a mold chase top 704 in a transfer molding process enables the formation of many differently shaped fluid channels 128. This is achieved by providing mold chase tops 704 that have varying topographical designs. In general, the resulting shapes of the fluid channels 128 follow, inversely, the contours of the topography of the top mold chase 704 used in the transfer mold process. FIGs. 9-15 illustrate several examples of differently shaped, transfer molded fluid channels 128.

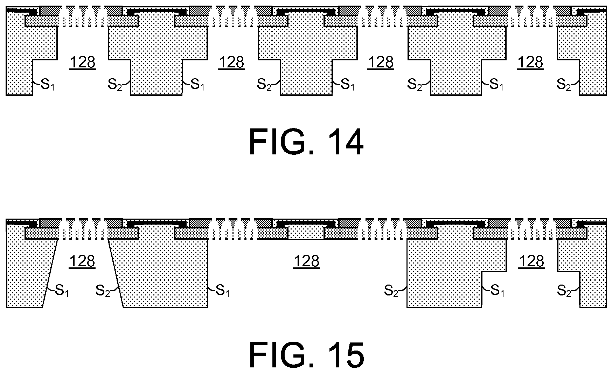

Referring to FIG. 9, transfer molded fluid channels 128 have been formed with first and second side walls, S₁ and S₂, that are substantially straight and parallel to one another. FIG. 10 shows transfer molded fluid channels 128 whose side walls S₁ and S₂, are straight and tapered with respect to one another. The tapered side walls taper inward toward one another as they get closer to the fluid feed holes 108 in substrate 106, and away from one another as they recede from substrate 106. In FIG. 11, the side walls S₁ and S₂ of the transfer molded fluid channels 128 are curved inward in a manner that narrows the channels as they approach the fluid feed holes 108 in substrate 106. The transfer molded fluid channels 128 of FIGs. 12 and 13 show examples of sidewalls that include straight wall portions that are parallel to one another, and curved wall portions that mirror one another. Thus, a single side wall of a transfer molded fluid channel 128 can have multiple shape profiles such as straight, slanted, and curved profiles, in varying combinations and configurations. FIG. 14 shows transfer molded fluid channels 128 whose side walls S₁ and S₂, each have two straight sections that are substantially parallel to the opposite sidewall sections. FIG. 15 shows an example of a monolithic transfer molded printhead structure 100 whose multiple molded fluid channels 128 are shaped differently among themselves. In this example, one channel includes side walls with tapered shapes while another channel includes side walls with straight shapes. In addition, the center fluid channel shown in FIG. 15 illustrates one example of how transfer molded fluid channels can be formed to be fluidically coupled with multiple thin silicon sliver substrates 106 for multiple printhead dies 102.

In general, the transfer molded fluid channels 128 shown in FIGs. 9-15 have channel side walls, S₁ and S₂, formed in various straight and/or curved configurations that are parallel and/or tapered and/or mirrored to one another. In most cases, it is beneficial to have the channel side walls diverge or taper away from one another as they recede (i.e., move away) from the printhead sliver substrate 106. This divergence provides the benefit of assisting air bubbles move away from the orifices 120, ejection chambers 118, and fluid feed holes 108, where they may otherwise hinder or prevent the flow of fluid. Accordingly, the fluid channels 128 shown in FIGs. 9-15 comprise side walls that are typically divergent, but that are at least parallel, as they recede from the sliver substrate 106. However, the illustrated channel side wall shapes and configurations are not intended to be a limitation as to other shapes and configurations of side walls within fluid channels 128 that can be formed using a transfer molding process.

## Claims

1. A fluid flow structure (100), comprising:
a fluid ejecting micro device (102) embedded in a molded body (104);
an ejection chamber (118) having a corresponding orifice (120);
a fluid feed hole (108) formed through the micro device (102); and
a transfer molded fluid channel (128) in the molded body (104) that is fluidically coupled to the fluid feed hole (108), wherein the channel (128) comprises first and second side walls (S₁, S₂) that diverge from one another as they extend away from the micro device (102) and converge toward one another as they near the micro device (102).

2. A structure as in claim 1, wherein the channel (128) has a shape with contours that inversely follow a topography of a mold chase (704) used to form the channel (128).

3. A structure as in claim 1, wherein the first and second straight side walls (S₁, S₂) are tapered with respect to one another.

4. A structure as in claim 1, wherein the first and second curved side walls (S₁, S₂) mirror one another.

5. A structure as in claim 1, each side wall (S₁, S₂) having multiple contours selected from the group consisting of a straight contour, a tapered contour, and a curved contour.

6. A structure as in claim 1, wherein the multiple contours of the first side wall (S₁) mirror the multiple contours of the second side wall (S₂).

7. A fluid flow structure (100) according to any of the preceding claims, wherein:
the molded body (104) is a monolithic body (104) formed via transfer molding around multiple printhead sliver substrates (106) and incorporating these substrates (106),
the structure (100) further comprising multiple transfer molded fluid channels (128) in the body (104) fluidically coupled to the fluid feed holes (108) in the substrates (106).

8. A structure as in claim 7, wherein the channels (128) have shapes different from each other.

9. A structure as in claim 7, wherein a single channel (128) is fluidically coupled to multiple substrates (106).

10. A structure as in any of the preceding claims, wherein a plurality of micro devices (102) are arranged in a staggered configuration in which micro devices in each row overlap another micro device in that same row.

11. A method (800) of making a fluid channel (128) in a fluid flow structure (100), comprising:
attaching a printhead die (102) to a carrier (160), forming a die carrier assembly (700), the printhead die (102) having a first and a second exterior surfaces (110, 112);
positioning the die carrier assembly (700) onto a bottom mold chase (702) so that the second exterior surface (112) is directed to the bottom mold chase (702);
positioning a top mold chase (704) over the die carrier assembly (700), creating a cavity (706) between the top and bottom mold chases (702, 704), so that the top mold chase (704) seals the ink feed holes (108) at the first exterior surface (110) of the printhead die (102);
filling the cavity (706) with epoxy mold compound (708) so as to:
form a molded body (104) that encapsulates the printhead die (102); and
form a molded fluid channel (128) within the molded body (104) through which fluid can flow directly to the printhead die (102).

12. A method as in claim 11, wherein filing the cavity (706) with epoxy mold compound (708) comprises:
preheating the epoxy mold compound (708) to a liquid phase;
creating a vacuum within the cavity (706); and
injecting the liquid epoxy mold compound (708) into the cavity (706).

13. A method as in claim 11 or 12, further comprising:
cooling the epoxy mold compound (708);
removing the die carrier assembly (700) with the molded body (104) from the top and bottom mold chase (702, 704); and
releasing the molded body (104) from the carrier (160).

## Patentansprüche

1. Fluidstromstruktur (100), umfassend:
eine Fluid ausstoßende Mikrovorrichtung (102), die in einem geformten Körper (104) eingebettet ist;
eine Ausstoßkammer (118) mit einer entsprechenden Öffnung (120);
ein Fluidzufuhrloch (108), das durch die Mikrovorrichtung (102) gebildet ist; und
einen spritzgepressten Fluidkanal (128) in dem geformten Körper (104), der fluidisch mit dem Fluidzufuhrloch (108) gekoppelt ist, wobei der Kanal (128) eine erste und eine zweite Seitenwand (S₁, S₂) umfasst, die in Richtung weg von der Mikrovorrichtung (102) auseinandergehen und in Richtung zur Mikrovorrichtung (102) hin zusammengehen.

2. Struktur nach Anspruch 1, wobei der Kanal (128) eine Form mit Konturen hat, die umgekehrt einer Topographie eines Formrahmens (704) folgen, der verwendet wird, um den Kanal (128) zu bilden.

3. Struktur nach Anspruch 1, wobei die erste und die zweite gerade Seitenwand (S₁, S₂) aufeinander zulaufen.

4. Struktur nach Anspruch 1, wobei die erste und die zweite gekrümmte Seitenwand (S₁, S₂) einander spiegeln.

5. Struktur nach Anspruch 1, wobei jede Seitenwand (S₁, S₂) mehrere Konturen aufweist, die ausgewählt sind aus der Gruppe bestehend aus einer geraden Kontur, einer konisch zulaufenden Kontur und einer gekrümmten Kontur.

6. Struktur nach Anspruch 1, wobei die mehreren Konturen der ersten Seitenwand (S₁) die mehreren Konturen der zweiten Seitenwand (S₂) spiegeln.

7. Fluidstromstruktur (100) gemäß einem der vorstehenden Ansprüche, wobei:
der geformte Körper (104) ein monolithischer Körper (104) ist, der durch Spritzpressen um mehrere Druckkopfscheibchensubstrate (106) gebildet wird und diese Substrate (106) inkorporiert,
wobei die Struktur (100) ferner mehrere, durch Spritzpressen geformte Fluidkanäle (128) in dem Körper (104) umfasst, die fluidisch mit den Fluidzufuhrlöchern (108) in den Substraten (106) gekoppelt sind.

8. Struktur nach Anspruch 7, wobei die Kanäle (128) voneinander verschiedene Formen aufweisen.

9. Struktur nach Anspruch 7, wobei ein einzelner Kanal (128) fluidisch mit mehreren Substraten (106) gekoppelt ist.

10. Struktur nach einem der vorstehenden Ansprüche, wobei mehrere Mikrovorrichtungen (102) in versetzter Konfiguration angeordnet sind, in der Mikrovorrichtungen in jeder Reihe eine andere Mikrovorrichtung in derselben Reihe überlappen.

11. Verfahren (800) zum Herstellen eines Fluidkanals (128) in einer Fluidstromstruktur (100), umfassend:
Anbringen einer Druckkopfdüse (102) an einem Träger (160) unter Bildung eines Düsenträgeraufbaus (700), wobei die Druckkopfdüse (102) eine erste und eine zweite Außenfläche (110, 112) aufweist;
Positionieren des Düsenträgeraufbaus (700) auf einem unteren Formrahmen (702), so dass die zweite Außenfläche (112) zum unteren Formrahmen (702) weist;
Positionieren eines oberen Formrahmens (704) über dem Düsenträgeraufbau (700), wobei ein Hohlraum (706) zwischen dem oberen und dem unteren Formrahmen (702, 704) gebildet wird, so dass der obere Formrahmen (704) die Tintenzufuhrlöcher (108) an der ersten Außenfläche (110) der Druckkopfdüse (102) abdichtet;
Füllen des Hohlraums (706) mit einer Epoxidformmasse (708), um:
einen geformten Körper (104) zu bilden, der die Druckkopfdüse (102) einkapselt; und
einen geformten Fluidkanal (128) innerhalb des geformten Körpers (104) zu bilden,
durch den Fluid direkt zur Druckkopfdüse (102) fließen kann.

12. Verfahren nach Anspruch 11, wobei das Füllen des Hohlraums (706) mit einer Epoxidformmasse (708) umfasst:
Vorwärmen der Epoxidformmasse (708) zu einer flüssigen Phase;
Schaffen eines Vakuums innerhalb des Hohlraums (706); und
Einspritzen der flüssigen Epoxidformmasse (708) in den Hohlraum (706).

13. Verfahren nach Anspruch 11 oder 12, ferner umfassend:
Kühlen der Epoxidformmasse (708);
Entfernen des Düsenträgeraufbaus (700) mit dem geformten Körper (104) von dem oberen und unteren Formrahmen (702, 704); und
Herauslösen des geformten Körpers (104) aus dem Träger (160).

## Revendications

1. Structure d'écoulement de fluide (100), comprenant :
un micro-dispositif à éjection de fluide (102) intégré dans un corps moulé (104) ;
une chambre d'éjection (118) ayant un orifice correspondant (120) ;
un trou d'alimentation en fluide (108) formé à travers le micro-dispositif (102) ; et
un canal de fluide moulé par transfert (128) dans le corps moulé (104) qui est couplé de manière fluidique au trou d'alimentation en fluide (108), le canal (128) comprenant des première et seconde parois latérales (S₁, S₂) qui divergent l'une de l'autre tandis qu'elles s'éloignent du micro-dispositif (102) et convergent l'une vers l'autre tandis qu'elles se rapprochent du micro-dispositif (102).

2. Structure selon la revendication 1, dans laquelle le canal (128) a une forme avec des contours qui suivent inversement une topographie d'un châssis de moule (704) utilisé pour former le canal (128).

3. Structure selon la revendication 1, dans laquelle les première et seconde parois latérales droites (S₁, S₂) sont effilées l'une par rapport à l'autre.

4. Structure selon la revendication 1, dans laquelle les première et seconde parois latérales incurvées (S₁, S₂) se reflètent l'une l'autre.

5. Structure selon la revendication 1, chaque paroi latérale (S₁, S₂) ayant de multiples contours choisis dans le groupe composé d'un contour droit, d'un contour effilé et d'un contour incurvé.

6. Structure selon la revendication 1, dans laquelle les multiples contours de la première paroi latérale (S₁) reflètent les multiples contours de la seconde paroi latérale (S₂).

7. Structure d'écoulement de fluide (100) selon l'une quelconque des revendications précédentes, dans laquelle :
le corps moulé (104) est un corps monolithique (104) formé via un moulage par transfert autour de multiples substrats de ruban de tête d'impression (106) et incorporant ces substrats (106),
la structure (100) comprenant en outre de multiples canaux de fluide moulés par transfert (128) dans le corps (104) couplés de manière fluidique aux trous d'alimentation en fluide (108) dans les substrats (106).

8. Structure selon la revendication 7, dans laquelle les canaux (128) ont des formes différentes les unes des autres.

9. Structure selon la revendication 7, dans laquelle un canal unique (128) est couplé de manière fluidique à de multiples substrats (106).

10. Structure selon l'une quelconque des revendications précédentes, dans laquelle une pluralité de micro-dispositifs (102) sont agencés dans une configuration échelonnée dans laquelle les micro-dispositifs dans chaque rangée chevauchent un autre micro-dispositif dans cette même rangée.

11. Procédé (800) de réalisation d'un canal de fluide (128) dans une structure d'écoulement de fluide (100), comprenant :
la fixation d'une matrice de tête d'impression (102) à un support (160), formant un ensemble porte-matrice (700), la matrice de tête d'impression (102) ayant une première et une seconde surfaces extérieures (110, 112) ;
le positionnement de l'ensemble porte-matrice (700) sur un châssis de moule inférieur (702) de sorte que la seconde surface extérieure (112) est dirigée vers le châssis de moule inférieur (702) ;
le positionnement d'un châssis de moule supérieur (704) sur l'ensemble porte-matrice (700), créant une cavité (706) entre les châssis de moule supérieur et inférieur (702, 704), de sorte que le châssis de moule supérieur (704) bouche de manière étanche les trous d'alimentation en encre (108) sur la première surface extérieure (110) de la matrice de tête d'impression (102) ;
le remplissage de la cavité (706) avec un composé de moule époxy (708) de manière à :
former un corps moulé (104) qui enferme la matrice de tête d'impression (102) ; et
former un canal de fluide moulé (128) à l'intérieur du corps moulé (104) à travers lequel le fluide peut s'écouler directement jusqu'à la matrice de tête d'impression (102).

12. Procédé selon la revendication 11, dans lequel le remplissage de la cavité (706) avec un composé de moule époxy (708) comprend :
le préchauffage du composé de moule époxy (708) jusqu'à une phase liquide ;
la création d'un vide à l'intérieur de la cavité (706) ; et
l'injection du composé de moule époxy liquide (708) dans la cavité (706).

13. Procédé selon la revendication 11 ou 12, comprenant en outre :
le refroidissement du composé de moule époxy (708) ;
le retrait de l'ensemble porte-matrice (700) avec le corps moulé (104) du châssis de moule supérieur et inférieur (702, 704) ; et
la libération du corps moulé (104) du support (160).
